(19) Europäisches Patentamt
European Patent Office
Office européen des brevets

(11) **EP 2 793 038 B1**

(12) **EUROPEAN PATENT SPECIFICATION**

(45) Date of publication and mention
of the grant of the patent:
**06.05.2020 Bulletin 2020/19**

(51) Int Cl.:
***G01R 31/3842*** *(2019.01)*  ***G01R 31/389*** *(2019.01)*
***G01R 31/36*** *(2020.01)*

(21) Application number: **14165260.2**

(22) Date of filing: **17.04.2014**

(54) **Battery management system and driving method thereof**

Batterieverwaltungssystem und Antriebsverfahren dafür

Système de gestion de batterie et son procédé de commande

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.04.2013 KR 20130043023**

(43) Date of publication of application:
**22.10.2014 Bulletin 2014/43**

(60) Divisional application:
**15173421.7 / 2 952 922**

(73) Proprietor: **Samsung SDI Co., Ltd.
Yongin-si, Gyeonggi-do (KR)**

(72) Inventors:
• **Cho, Young-Shin
Gyeonggi-do (KR)**
• **Lee, Soo-Jin
Gyeonggi-do (KR)**
• **Shim, Young-Woo
Gyeonggi-do (KR)**

(74) Representative: **Taor, Simon Edward William et al
Venner Shipley LLP
200 Aldersgate
London EC1A 4HD (GB)**

(56) References cited:
EP-A1- 2 071 345     EP-A2- 0 055 349
EP-A2- 1 065 773     FR-A1- 2 934 374
US-A- 5 631 540      US-A- 5 936 383
US-A- 6 160 380      US-A1- 2004 128 089
US-A1- 2008 255 783  US-A1- 2012 029 851
US-A1- 2013 041 607

EP 2 793 038 B1

**Description**

The disclosed technology generally relates to a battery management system and a method of using the same. More particularly, the disclosed technology relates to a battery management system for managing the capacity of a battery.

Due to a growing demand, technologies relating to high-power and high-energy secondary batteries using non-aqueous electrolytes have advanced tremendously. In order to form a high-capacity secondary battery module, a plurality of high-power secondary battery cells can be connected in series or in parallel. The modules can in turn be assembled into a high-capacity battery pack. A battery cell is the smallest unit that can be integrated into a battery module, which typically includes several battery cells. A battery pack in turn typically includes several battery modules. While the battery management system disclosed herein can be applied at any level of integration, for simplicity, an integrated unit of battery cells is simply referred to hereinafter as a "battery."

In order to maximize the efficient use of a battery, a battery management system (BMS) is often employed to estimate various capacities of the battery through monitoring battery parameters such as the voltage, the current, and the temperature at a given discharge condition of the battery. In order to accurately estimate one capacity value, other capacity values also need to be accurately estimated. For example, the accuracy of estimation of the remaining capacity of the battery depends on the accuracy of estimation of other capacities of the battery, such as the theoretical maximum capacity and the unusable capacity, among others. While many BMS are equipped to estimate these capacities using fixed correlations such as the open circuit voltage versus the state of charge, they do not take into account of the changing nature (e.g., during a charge/discharge cycle or through degradation) of various characteristics of the battery. For example, parameters such as the internal resistance of the battery not only change as a function of depth of discharge, but also as a function of battery degradation. Thus, there is a need for a BMS capable of accurately estimating various capacities of the battery that takes into account of the changing characteristics.

US2013041607 discloses a battery monitoring circuit is that includes a high counter that increments when a sense voltage measurement is above a threshold. The battery monitoring circuit also includes a low counter that increments when the sense voltage measurement is below the threshold.

US5936383 discloses an apparatus and method of predicting remaining capacity and reserve time of a discharging battery to a selected end voltage determined by an arrangement considering the open circuit voltage, battery voltage, battery temperature, and battery internal resistance. The apparatus utilizes a calculation process which first compares calculated and measured capacity discharged between two times. If this difference exceeds a certain predetermined tolerance or limit of error, the calculation process is adjusted and the comparison is repeated until the difference between the actual capacity and the calculated capacity are within a predetermined tolerance.

EP2071345 discloses a comparing a measured voltage at terminals of a battery of a motor vehicle based on a time with a group of voltage curves based on the time to determine target voltage curves that are the voltage curves of the group nearer to the measured voltage.

US5631540 discloses a method of predicting remaining capacity and reserve time of a discharging battery to a selected end voltage by an arrangement considering the open circuit voltage, battery voltage, battery temperature and its internal resistance.

A battery management system configured to accurately estimate the capacity of a battery is disclosed.

Other objects of the present invention will be derived by those skilled in the art through the following embodiments.

According to an aspect of the invention, there is provided a battery management system as set out in claim 1. Preferred features are set out in claims 2 to 9.

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the example embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.

FIG. 1 is a view three-dimensional view of a battery according to an embodiment.

FIG. 2 is a block diagram schematically illustrating a battery management system (BMS) according to an embodiment.

FIG. 3 is a graph illustrating the relationship between open circuit voltage (OCV) and state of charge (SOC) according to an embodiment.

FIG. 4 is a graph illustrating the relationship among unusable capacity, current, temperature and internal resistance according to an embodiment.

FIG. 5 is a graph illustrating the relationship between internal resistance and depth of discharge (DoD) of a battery according to an.

FIG. 6 is a graph illustrating the relationship among maximum capacity, total usable capacity, uncharged capacity, used capacity, unusable capacity and remaining capacity of a battery according to an embodiment.

FIG. 7 is a flowchart illustrating a driving method of the BMS according to an embodiment.

Hereinafter, certain exemplary embodiments according to the present invention will be described with reference to the accompanying drawings. Here, when a first element is described as being coupled to a second element, the first element may be not only directly coupled to the second element but may also be indirectly coupled to the second element via a third element. Further, some of the elements that are not essential to the complete understanding of the invention are omitted for clarity. Also, like reference numerals refer to like elements throughout.

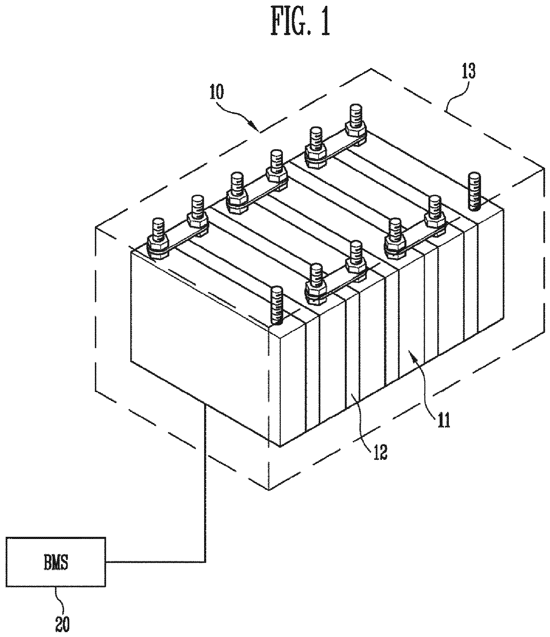

FIG. 1 is a view illustrating a battery according to an embodiment.

Referring to FIG. 1, the battery 10 as a large-capacity battery module includes a plurality of secondary batteries 11 consecutively arranged at a predetermined interval; a housing 13 accommodating the plurality of secondary batteries 11 therein and having a cooling medium moved therein; and a battery management system 20 managing charge/discharge of the battery 10.

Battery partition walls 12 may be respectively arranged between the secondary batteries and at the outermost secondary batteries 11. The battery partition wall 12 performs a function of allowing air for temperature control to be moved while constantly maintaining the interval between the secondary batteries 11, and supporting side surfaces of each secondary battery 11.

The driving method may further include calculating a total usable capacity of the battery, using a maximum capacity of the battery, the uncharged capacity of the battery and the unusable capacity.

The driving method may further include calculating an actually usable remaining capacity of the battery, using the total usable capacity, the uncharged capacity, the used capacity and an integrated current obtained by integrating the current value from the calculation time of the used capacity to the current time.

According to various aspects, it is possible to efficiently calculate the capacity of a battery in consideration of a current discharge condition.

According to an aspect of the invention, there is provided a battery management system as set out in claim 1. Preferred features are set out in claims 2 to 9.

According to an aspect of the invention, there is provided a battery management system as set out in claim 1

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the example embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.

FIG. 1 is a view three-dimensional view of a battery according to an embodiment.

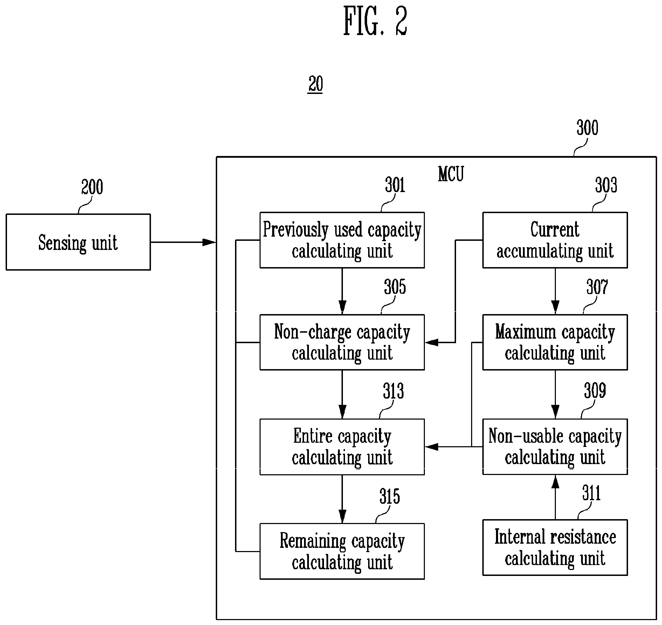

FIG. 2 is a block diagram schematically illustrating a battery management system (BMS) according to an embodiment.

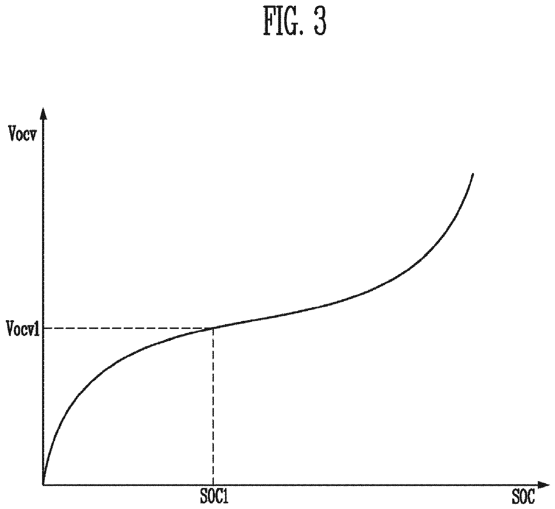

FIG. 3 is a graph illustrating the relationship between open circuit voltage (OCV) and state of charge (SOC) according to an embodiment.

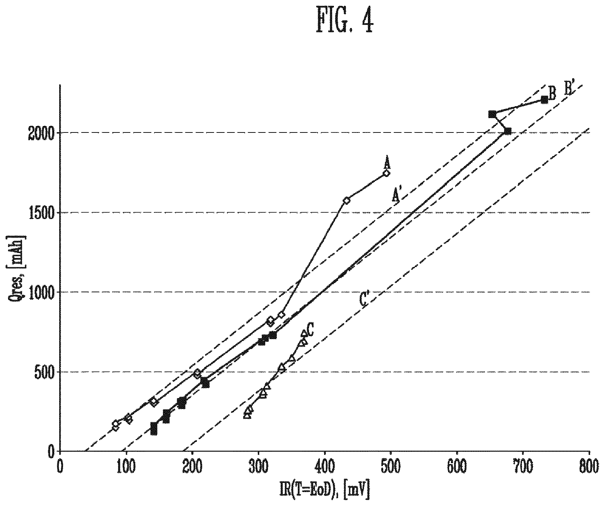

FIG. 4 is a graph illustrating the relationship among unusable capacity, current, temperature and internal resistance according to an embodiment.

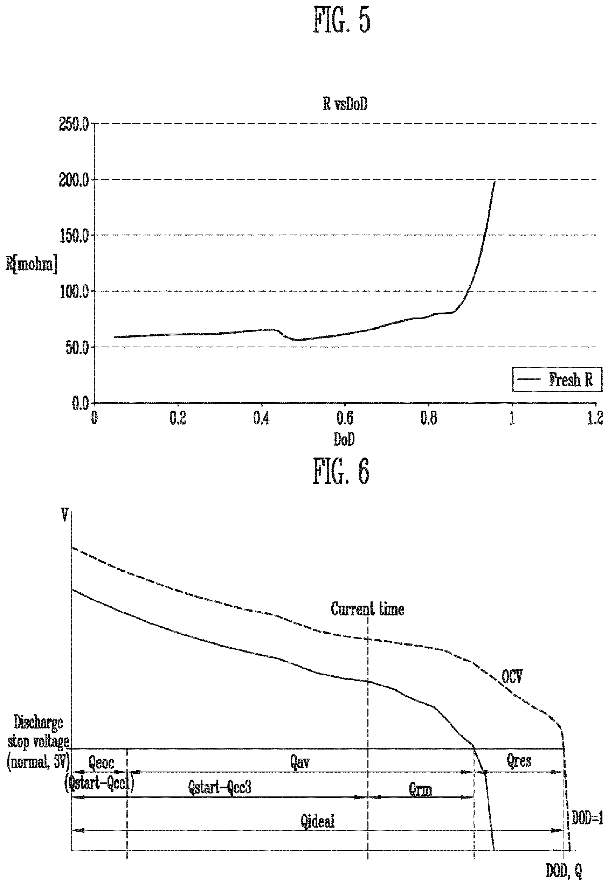

FIG. 5 is a graph illustrating the relationship between internal resistance and depth of discharge (DoD) of a battery according to an.

FIG. 6 is a graph illustrating the relationship among maximum capacity, total usable capacity, uncharged capacity, used capacity, unusable capacity and remaining capacity of a battery according to an embodiment.

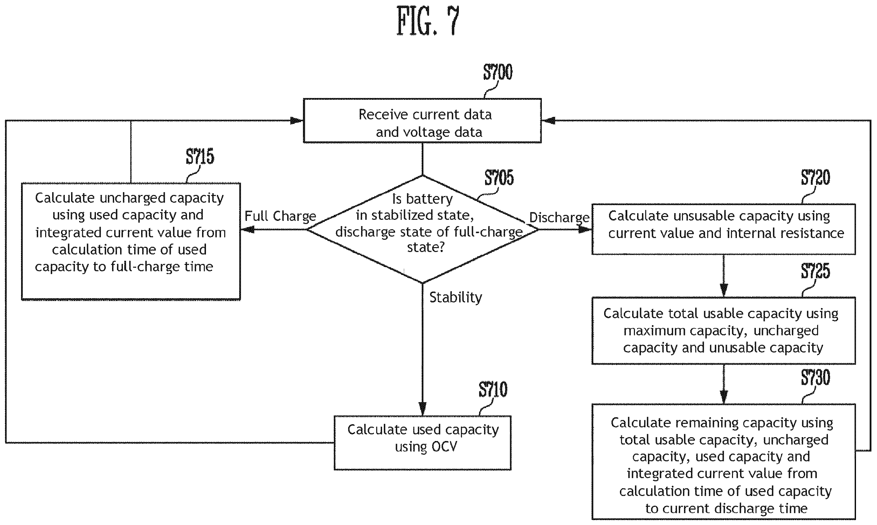

FIG. 7 is a flowchart illustrating a driving method of the BMS according to an embodiment.

Hereinafter, certain exemplary embodiments according to the present invention will be described with reference to the accompanying drawings. Here, when a first element is described as being coupled to a second element, the first element may be not only directly coupled to the second element but may also be indirectly coupled to the second element via a third element. Further, some of the elements that are not essential to the complete understanding of the invention are omitted for clarity. Also, like reference numerals refer to like elements throughout.

FIG. 1 is a view illustrating a battery according to an embodiment.

Referring to FIG. 1, the battery 10 as a large-capacity battery module includes a plurality of secondary batteries 11 consecutively arranged at a predetermined interval; a housing 13 accommodating the plurality of secondary batteries 11 therein and having a cooling medium moved therein; and a battery management system 20 managing charge/discharge of the battery 10.

Battery partition walls 12 may be respectively arranged between the secondary batteries and at the outermost secondary batteries 11. The battery partition wall 12 performs a function of allowing air for temperature control to be moved while constantly maintaining the interval between the secondary batteries 11, and supporting side surfaces of each secondary battery 11.

Although it has been illustrated in FIG. 1 that the secondary batteries 11 has a quadrangular structure, it will be apparent that the secondary batteries 11 may have a cylindrical structure.

The BMS 20 receives data from a current sensor, a voltage sensor and a temperature sensor, which are mounted in the battery 10, and manages the capacity of the battery 10, using the data.

Some methods of calculating the capacity of a general battery 10 simultaneously use integrated current using discharge efficiency of the battery 10 and capacity correction using voltage at the last stage of discharge. For example, in case of the full-charged battery 10, the capacity of the battery is calculated using a discharge efficiency table and an integrated current value at the initial and middle stages of discharge, and the calculated capacity is corrected using the voltage of the battery 10 at the last stage of discharge.

However, the method has three problems as follows. A first problem is that parameters (in a discharge efficiency table and a voltage correction table) used to calculate the capacity of the battery 10 are used as fixed values. However, characteristics of the battery 10 are changed as the degradation of the battery 10 is advanced, and therefore, the accuracy of the method is decreased as time elapses.

A second problem results from calculation of self-discharge. The self-discharge is a phenomenon that the battery 10 is naturally discharged during a period in which the battery 10 is not used. The capacity of the battery 10 discharged described above cannot be measured through current measurement, and hence the method reflects an arbitrarily fixed value as time elapses. However, there is a problem in that the accuracy of the method is decreased.

A third problem is that the discharge experience from full charge to full discharge of the battery 10 is required in order to detect the total usable capacity of the battery 10. However, a case where the battery 10 is discharged near the full discharge hardly exists in an actual use environment. Therefore, it is less likely that the total usable capacity of the battery 10 can be calculated. The three problems described above become main factors that contribute to an error in calculating the capacity of the battery 10.

Thus, the BMS 20 of some embodiments of the present invention calculates used capacity of the battery, uncharged capacity of the battery, maximum capacity of the battery, unusable capacity of the battery, actually usable capacity of the battery, remaining capacity of the battery, etc., in consideration of current discharge conditions, so that the capacity of a battery can be exactly calculated even under an environment in which the battery is partially charged/discharged.

FIG. 2 is a block diagram schematically illustrating a BMS according to an embodiment.

As shown in FIG. 2, the BMS 20 includes a sensing unit 200 and a main controller unit (MCU) 300.

The sensing unit 200 obtains current value, voltage value and temperature value by measuring output current, voltage and temperature of a battery through a current sensor, a voltage sensor and a temperature sensor, respectively, and transmits the obtained data to the MCU 300.

According to an embodiment, the MCU 300 includes a used capacity calculating unit 301, a current integration unit 303, an uncharged capacity calculating unit 305, a maximum capacity calculating unit 307, a unusable capacity calculating unit 309, an internal resistance calculating unit 311, a total usable capacity calculating unit 313, and a remaining capacity calculating unit 315.

The used capacity calculating unit 301 calculates the used capacity of the battery, using an open circuit voltage (OCV) that is a voltage value obtained at the time when the battery is stabilized.

As used herein, the stabilized time of the battery refers to a discharge condition that satisfies at least one of a case where the magnitude of current discharged during a predetermined time is less than a predetermined value and a case where the change in voltage of the battery is less than a predetermined value.

More specifically, the used capacity calculating unit 301 estimates a state of charge (SOC) from the OCV that is the voltage value at the time when the battery is stabilized and relational data between the OCV and the SOC. Specifically, the MCU 300 may previously store relation data experimentally obtained from the relationship between the OCV and the SOC. The relationship is shown in the graph of FIG. 3. As shown in FIG. 3, the used capacity calculating unit 301 detects an SOC (SOC1) corresponding to the OCV (Vocv1). Subsequently, the used capacity calculating unit 301 calculates the used capacity of the battery from the estimated SOC.

For example, when assuming that the maximum capacity of the battery is 1000mA/h and the estimated SOC of the battery is 40%, the used capacity of the battery may be calculated as 600mA/h that is 60% of the maximum capacity.

The current integration unit 303 calculates an integrated current value obtained by integrating the current value obtained in the sensing unit 200.

Here, the current value may include charge current having a positive (+) value and discharge current having a negative (-) value. Therefore, if the battery is charged and discharged with the same amount, the integrated current value becomes zero.

In embodiments disclosed herein, the calculation time of the used capacity of the battery becomes a reference time for integrating the measured current value. That is, the current integration unit 303 sets, as zero, the integrated current value at the calculation time of the used capacity, and calculates an integrated current value by integrating current value obtained thereafter.

The uncharged capacity calculating unit 305 calculates an uncharged capacity of the battery, using the used capacity of the battery, calculated in the used capacity calculating unit 301, and the integrated current value calculated in the current integration unit 303.

Generally, a battery is not charged up to the maximum capacity according to temperature and internal resistance. That is, although the battery may be considered to be fully charged, there occurs a capacity to which the battery is not charged. In embodiments of the present invention, the capacity is defined as an uncharged capacity.

Therefore, the integrated current value for calculating the uncharged capacity may be a first integrated current value obtained by accumulating current value until the full-charge time of the battery.

Here, the full-charge time may mean a time when the magnitude of the voltage value obtained in the sensing unit 200 is greater than or equal to a predetermined full-charge voltage value and when the magnitude of the current value obtained in the sensing unit 200 is less than a predetermined value. In this case, the full-charge voltage value is a value changeable depending on the capacity of the battery. The method of recognizing the full-charge time defined as described above is merely an embodiment, and it will be apparent to those skilled in the art that various changes and modifications may be made thereto without departing from the scope of the invention.

According to an embodiment, Equation 1 for calculating an uncharged capacity may be represented as follows.

## Equation 1

$$Q_{eoc} = Q_{start} - Q_{cc1}$$

Here, $Q_{eoc}$ denotes an uncharged capacity, $Q_{start}$ denotes a used capacity, and $Q_{cc1}$ denotes a first integrated current value.

For example, in a case where the used capacity is 600mA/h and the first integrated current value at the moment when the voltage value becomes the full-charge voltage value or more, the uncharged capacity may be 100mA/h.

The maximum capacity calculating unit 307 calculates the theoretical maximum capacity of the battery. More specifically, the maximum capacity calculating unit 307 may calculate the maximum capacity of the battery, using a first depth of discharge (DoD) calculated using a first OCV that is a voltage value obtained at a first stabilized time just before the last charge or discharge of the battery, a second DoD calculated using a second OCV that is a voltage value obtained at a second stabilized time after the last charge or discharge of the battery, and a second integrated current value obtained by accumulating current value from the calculation time of the used capacity to the second stabilized time.

Here, the stabilized time of the battery may mean a time to satisfy at least one of a case where the current of the battery is not discharged during a predetermined time and a case where the change in voltage of the battery is less than a predetermined value.

According to an embodiment, Equation 2 for calculating the maximum capacity may be represented as follows.

## Equation 2

$$Q_{ideal} = \frac{Q_{cc2}}{DoD_1 - DoD_2}$$

Here, $Q_{ideal}$ denotes the maximum capacity, $Q_{cc2}$ denotes the second integrated current value, $DoD_1$ denotes a first DoD, and $DoD_2$ denotes a second DoD.

In this case, the DoD may be represented by the following Equation 3.

## Equation 3

$$SOC[\%] = 100(1 - DoD)$$

Here, the DoD has a range of 0 to 1. That is, the DoD in the full-charge of the battery has a value of 0, and the DoD in the full-discharge of the battery has a value of 1.

Thus, the maximum capacity calculation unit 307 estimates an SOC, using the first OCV obtained at the first stabilized time, and estimates an SOC, using the second OCV obtained at the second stabilized time. The maximum capacity calculation unit 307 calculates the first DoD and the second DoD, using Equation 3.

According to an embodiment, the maximum capacity calculating unit 307 may calculate the maximum capacity when the second integrated current value is no less than a predetermined value. For example, the maximum capacity calculating unit 307 may calculate the maximum capacity when the second integrated current value is no less than 20% of the maximum capacity calculated before the second integrated current value. This is because, when the second integrated current value is too small, the error of the calculated maximum capacity may be large.

The unusable capacity calculating unit 309 calculates a unusable capacity under the current discharge condition of the battery, using current value and internal resistance of the battery.

Here, the unusable capacity means a remaining capacity that remains in the battery when the voltage value reaches a discharge stop voltage according to the discharge of the battery. That is, the minimum necessary voltage exists in order to drive a device using the battery. In a case where the output voltage of the battery drops to the minimum necessary voltage or less, the device cannot be operated. That is, the unusable capacity of the battery does not mean that the battery is completely discharged, but means a remaining capacity that remains in the battery when the voltage value of the battery drops to the minimum voltage for driving the device, i.e., the discharge stop voltage or less.

According to an embodiment, the unusable capacity calculating unit 309 may calculate the unusable capacity under the current discharge condition of the battery, further using discharge current previously stored in the MCU and a proportional coefficient between the internal resistance and unusable capacity of the battery.

In this case, the discharge condition may mean at least one of the magnitude of the current value in the discharge of the battery and the magnitude of the temperature value, and the unusable capacity may be represented by the following Equation 4.

Equation 4

$$Q_{res} = \gamma I \left( R_o(T) - R_d \right)$$

Here, $Q_{res}$ denotes the unusable capacity, $\gamma$ denotes the proportional coefficient, I denotes current value in discharge, $R_o(T)$ denotes the internal resistance of the battery, and $R_d$ denotes a correction variable.

The correction variable means a value determined according to the magnitude of the current value in the discharge of the battery, and corrects an internal resistance value of the battery.

FIG. 4 is a graph illustrating the relationship among unusable capacity, current, temperature and internal resistance according to an embodiment of the present invention.

Referring to FIG. 4, graphs A, B and C are graphs according to Equation 4 when the magnitudes of discharge current of a battery are respectively a, b and c, and graphs A', B' and C' are graphs illustrating the relationship among unusable capacity, current, temperature and internal resistance, which are experimentally obtained when the sizes of discharge current of the battery are respectively a, b and c. Here, a, b and c have the relation of a<b<c.

In the graph of FIG. 4, the Y-axis denotes the unusable capacity ($Q_{res}$), the X-axis denotes the multiplication of current value and internal resistance, the slope of the graph denotes the proportional coefficient ($\gamma$), and the y-intercept denotes the relationship between the correction variable ($R_d$) and the current value. Therefore, the proportional coefficient ($\gamma$) and the correction variable ($R_d$) may be determined through the graphs A', B' and C' respectively obtained by approximating the experimentally obtained graphs A, B and C to primary expressions.

According to an embodiment, the internal resistance refers to a resistance value normalized according to the temperature of the battery, and the internal resistance calculating unit 311 may calculates an internal resistance of the battery, using the following Equation 5.

Equation 5

$$R_O(T) = R_a \alpha(T)$$

$$R_a = \frac{(Voc\upsilon - V)}{I\alpha(T)}$$

Here, $R_o(T)$ denotes an internal resistance, $R_a$ denotes a reference internal resistance, $\alpha(T)$ denotes a temperature correction variable, $Voc\upsilon$ denotes an OCV voltage estimated using the SOC and the relation data between OCV and SOC, $I$ denotes a current value in discharge, V denotes a voltage value in discharge.

More specifically, the reference internal resistance ($R_a$) refers to a value calculated using the OCV, current value, voltage value and temperature correction value, which are estimated using the SOC at an arbitrary point in the region where the *DoD* of the battery is 0 to 0.7. Preferably, the reference internal resistance ($R_a$) may be a resistance value calculated in a state in which the *DoD* of the battery is 0.4.

The temperature correction variable is $\alpha(T)$ determined based on a relationship between the temperature value and the internal resistance.

FIG. 5 is a graph illustrating the relationship between internal resistance and DoD of a battery according to an embodiment of the present invention.

Referring to FIG. 5, the internal resistance value in the region where the *DoD* of the battery is 0 to 0.7 is roughly flat, and in the range of 0 to 0.7 has a value smaller than the internal resistance value when the *DoD* of the battery exceeds 0.7. Thus, it is possible to decrease an error value of the unusable capacity calculated when the internal resistance value in the region where the DoD of the battery is 0 to 0.7, preferably when the *DoD* of the battery is 0.4, is used.

For example, when the DoD of the battery is 0.4, the SOC has a value of 60% according to Equation 3. The internal resistance calculating unit 311 calculates $Voc\upsilon$, using the relation value between OCV and SOC shown in FIG. 3, and calculates the reference internal resistance ($R_a$), using the measured current value and voltage value. The internal resistance of the battery may have different internal resistance values according to the temperature of the battery under the same DoD condition. Thus, in order to standardize the internal resistance values, the internal resistance calculating unit 311 corrects the reference internal resistance ($R_a$), using temperature correction variable ($\alpha(T)$) according to the temperature value when the DoD of the battery is 0.4. Here, the temperature correction variable ($\alpha(T)$) denotes the relation data between temperature and internal resistance for standardizing internal resistance values.

Subsequently, the internal resistance calculating unit 311 calculates internal resistance ($R_o(T)$) for calculating the unusable capacity ($Q_{res}$), using the reference internal resistance ($R_a$) and the temperature correction variable according to the temperature in the discharge of the battery.

The total usable capacity calculating unit 313 is configured to calculate a total usable capacity under the current discharge condition of the battery, using the uncharged capacity, the maximum capacity and the unusable capacity, which are calculated as described above. The total usable capacity of the battery may be represented by the following Equation 6.

### Equation 6

$$Q_{av} = Q_{ideal} - Q_{eoc} - Q_{res}$$

Here, $Q_{av}$ denotes the total usable capacity, $Q_{ideal}$ denotes the maximum capacity, $Q_{eoc}$ denotes the uncharged capacity, and $Q_{res}$ denotes the unusable capacity.

The remaining capacity calculating unit 315 calculates a remaining capacity that remains under the current discharge condition, using the total usable capacity, the uncharged capacity, used capacity and a third integrated current value obtained by accumulating current value from the calculation time of the used capacity to the current time. The remaining capacity of the battery may be represented by the following Equation 7.

### Equation 7

$$Q_{rm} = Q_{av} + Q_{eoc} - Q_{start} + Q_{cc3}$$

Here, $Q_{rm}$ denotes the remaining capacity of the battery, $Q_{av}$ denotes the total usable capacity, $Q_{eoc}$ denotes the uncharged capacity, $Q_{start}$ denotes the used capacity, and $Q_{cc3}$ denotes the third integrated current value.

FIG. 6 is a graph illustrating the relationship among maximum capacity, total usable capacity, uncharged capacity, used capacity, unusable capacity and remaining capacity of a battery according to an embodiment of the present invention.

Referring to FIG. 6, the BMS 20 of this embodiment of present invention calculates the uncharged capacity ($Q_{eoc}$), using the difference between the used capacity ($Q_{start}$) and the first integrated current value ($Q_{cc1}$), and calculates the total usable capacity ($Q_{av}$) usable according to the present discharge condition of the battery by calculating the present unusable capacity ($Q_{res}$). That is, in this embodiment of the present invention, the total usable capacity is newly calculated in consideration of the current discharge condition, so that it is possible to more precisely manage the capacity of the battery. The BMS 20 can exactly calculate the current remaining capacity ($Q_{rm}$), using the total usable capacity ($Q_{av}$) usable at the current time, the uncharged capacity ($Q_{eoc}$), the used capacity ($Q_{start}$) and the third integrated current value ($Q_{cc3}$).

In other words, the capacities (unusable capacity, total usable capacity, remaining capacity, etc.) according to the current discharge condition are newly calculated every time, the degradation characteristic changed depending on the use of the battery can be further reflected as compared with the related art method of calculating the capacity of the battery using the discharge efficiency table and the integrated current. Further, it is possible to precisely manage the capacities of the battery even in a partial charge/discharge environment.

FIG. 7 is a flowchart illustrating a driving method of the BMS according to an embodiment of the present invention.

As shown in FIG. 7, the MCU 300 receives a current value and a voltage value of the battery, obtained from the sensing unit 200 (S700).

Subsequently, the MCU 300 decides whether the battery is in a stabilized state, discharge state or full-charge state, using the obtained current value and voltage value (S705).

In a case where the battery is in the stabilized state in step S705, the used capacity calculating unit 301 calculates a used capacity, using an OCV that is a voltage value measured at the stabilized time of the battery (S710).

In a case where the battery is in the full-charge state at step S705, the uncharged capacity calculating unit 305 calculates an uncharged capacity, using the calculated used capacity and an integrated current value obtained by accumulating current value from the calculation time of the used capacity to the full-charge time (S715).

In a case where the battery is in the discharge state in step S705, the unusable capacity calculating unit 309 calculates an unusable capacity, using the current value in the discharge of the battery and the internal resistance of the battery (S720).

Subsequently, the total usable capacity calculating unit 313 calculates a total usable capacity of the battery, using the maximum capacity, uncharged capacity and unusable capacity of the battery (S725).

Finally, the remaining capacity calculating unit 315 calculates a remaining capacity of the battery, using the total usable capacity of the battery, the uncharged capacity, the used capacity and the integrated current value from the calculation time of the used capacity to the current discharge time (S730).

As discussed above, embodiments of the invention provide a battery management system, comprising: a sensing unit configured to measure a current value and a voltage value of a battery under a discharge condition of the battery; and a main controller unit, MCU, configured to receive the current and voltage values and further configured to manage capacities of the battery based at least in part on the current and voltage values, wherein the MCU includes an unusable capacity calculating unit configured to calculate an unusable capacity corresponding to a portion of a theoretical maximum capacity of the battery that is unusable under the discharge condition, wherein the unusable capacity is calculated based at least in part on the current value and an internal resistance value of the battery under the discharge condition.

In some embodiments, the unusable capacity includes a portion of the theoretical maximum capacity that remains in the battery when the magnitude of the voltage value has reached a discharge stop voltage corresponding to a minimum voltage that is sufficient to drive a device connected to the battery.

In some embodiments, the sensing unit is further configured to measure a temperature value of the battery under the discharge condition. In some such embodiments, the battery management system is further configured to calculate the internal resistance based on a reference internal resistance, and a temperature correction value. In some such embodiments, the reference internal resistance is calculated based at least on one of an open circuit voltage, OCV, value estimated using a state of charge, SOC, value, a current value, a voltage value, and the temperature correction value, and the temperature correction variable is determined based on a relationship between the temperature value and the internal resistance.

In some embodiments, the unusable capacity calculating unit is configured to calculate the unusable capacity further based on the current value, a proportionality coefficient and the internal resistance. In some such embodiments, the unusable capacity calculating unit is further configured to make a correcting adjustment to the internal resistance of the battery based on a correction variable determined according to the magnitude of the current value. In some such embodiments, the unusable capacity is calculated by multiplying the proportionality coefficient by the current value and by a value obtained by subtracting the correction variable from the internal resistance of the battery.

In some embodiments, the MCU further includes a total usable capacity calculating unit configured to calculate a total usable capacity of the battery at least in part based on the theoretical maximum capacity of the battery, an uncharged capacity of the battery, and the unusable capacity. In some such embodiments, this is done by subtracting the uncharged capacity and the unusable capacity from the theoretical maximum capacity.

In some embodiments, the MCU further includes a used capacity calculating unit configured to calculate a used capacity of the battery at least in part based on an open circuit voltage (OCV) value measured at a time when the battery has been stabilized.

In some embodiments, the MCU further includes an uncharged capacity calculating unit configured to calculate the uncharged capacity based at least in part on the used capacity and a first integrated current value obtained by integrating the current value from the calculation time of the used capacity to a full-charge time of the battery. In some such embodiments, this is done by subtracting the first integrated current from the used capacity.

In some embodiments, the MCU further includes a remaining capacity calculating unit configured to calculate a remaining capacity that is available for use, using the total usable capacity, the uncharged capacity, the used capacity and a third integrated current value obtained by integrating the current value from the calculation time of the used capacity to a time when the remaining capacity is calculated. In some such embodiments, this is done by adding the total usable capacity and the uncharged capacity, subtracting the used capacity and adding the third integrated current value. In other such embodiments, this is done by adding the third integrated current value to the maximum capacity and subtracting the unusable capacity and the used capacity.

As discussed above, embodiments of the invention can also provide a battery management system, comprising: a sensing unit configured to measure a current value and a voltage value of a battery under a discharge condition of the battery; and a main controller unit, MCU, configured to receive the current and voltage values and further configured to manage capacities of the battery based at least in part on the current and voltage values, wherein the MCU includes: a used capacity calculating unit configured to calculate a used capacity of the battery, at least in part based on an open circuit voltage, OCV, value obtained at a time when the battery has been stabilized; and an uncharged capacity calculating unit configured to calculate an uncharged capacity of the battery, at least in part based on the used capacity and an integrated current value obtained by integrating the current value from a calculation time of the used capacity to a full-charge time of the battery.

As discussed above, embodiments of the invention can also provide a driving method of a battery management system, comprising: receiving a current value and a voltage value of a battery under a discharge condition of the battery; calculating a used capacity of the battery, at least in part based on an open circuit voltage, (OCV,) value obtained at a time when the battery has been stabilized; and calculating an uncharged capacity of the battery, based at least in part on a used capacity and an integrated current value obtained by integrating the current value from a calculation time of the used capacity to a full-charge time of the battery. In some such embodiments, the uncharged capacity is calculated by subtracting the integrated current value from the used capacity.

In some embodiments, the method can further comprise calculating an unusable capacity including a portion of a theoretical maximum capacity that is unusable under the discharge condition of the battery, based at least in part on the current value and an internal resistance value of the battery.

In some embodiments, the method can further comprise calculating a total usable capacity of the battery, based at least in part on a maximum capacity of the battery, the uncharged capacity of the battery and the unusable capacity. In some such embodiments, this is done by subtracting the uncharged capacity and the unusable capacity from the theoretical maximum capacity.

In some embodiments, the method can further comprise calculating a remaining capacity that is available for use, based at least in part on the total usable capacity, the uncharged capacity, the used capacity, and an integrated current value obtained by integrating the current value from a calculation time of the used capacity to the time when the remaining capacity is calculated. In some such embodiments, this is done by adding the total usable capacity and the uncharged capacity, subtracting the used capacity and adding the third integrated current value. In other such embodiments, this is done by adding the third integrated current value to the maximum capacity and subtracting the unusable capacity and the used capacity.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A battery management system (20), comprising:

   a sensing unit (200) configured to measure a current value and a voltage value and a temperature value of a battery under a discharge condition of the battery; and
   a main controller unit, MCU, (300) configured to receive the current, voltage and temperature values and further configured to manage capacities of the battery based at least in part on the current, voltage and temperature values, wherein the MCU (300) includes an unusable capacity calculating unit (309) configured to calculate an unusable capacity corresponding to a portion of a theoretical maximum capacity of the battery that is unusable under the discharge condition, wherein the unusable capacity is calculated based at least in part on the current value and an internal resistance value of the battery under the discharge condition;

   wherein the MCU (300) further includes an internal resistance calculating unit (311) to calculate the internal resistance value of the battery under the discharge condition based on:

   a temperature correction variable, wherein the temperature correction variable denotes relation data between temperature and internal resistance, and
   a reference internal resistance value, wherein the reference internal resistance is calculated using: an open-circuit voltage estimated using a state of charge of the battery at an arbitrary point in the region where the depth of discharge, DoD, of the battery is in the range 0 to 0.7; current and voltage values measured at the arbitrary point; and a value of the temperature correction variable calculated using a temperature value measured at the arbitrary point.

2. The battery management system of claim 1, wherein the unusable capacity includes a portion of the theoretical maximum capacity that remains in the battery when the magnitude of the voltage value has reached a discharge stop voltage corresponding to a minimum voltage that is sufficient to drive a device connected to the battery.

3. The battery management system of claim 1 or 2, wherein the unusable capacity calculating unit (309) is configured to calculate the unusable capacity further based on a previously stored current data in the MCU (300) and a proportionality coefficient between the internal resistance and the unusable capacity; optionally wherein the unusable capacity calculating unit (309) is further configured to make a correcting adjustment to the internal resistance of the battery based on a correction variable determined according to the magnitude of the current value.

4. The battery management system of any one of claims 1 to 3, wherein the MCU (300) further includes a total usable capacity calculating unit (313) configured to calculate a total usable capacity of the battery at least in part based on the theoretical maximum capacity of the battery, an uncharged capacity of the battery, and the unusable capacity.

5. The battery management system of claim 4, wherein the MCU (300) further includes a used capacity calculating unit (301) configured to calculate a used capacity of the battery at least in part based on an open circuit voltage, OCV, value measured at a time when the battery has been stabilized, wherein the time when the battery has been stabilized corresponds to a discharge condition satisfying at least one of the conditions of the current value during a predetermined time being less than a predetermined current value and a change in the voltage value being less than a predetermined voltage value.

6. The battery management system of claim 5, wherein the MCU (300) further includes a current integration unit (303) configured to calculate an integrated current value by integrating the current value at least in part by setting as zero the integrated current value at a time when the used capacity is calculated.

7. The battery management system of claim 6, wherein the MCU (300) further includes an uncharged capacity calculating unit (305) configured to calculate the uncharged capacity based at least in part on the used capacity and a first integrated current value obtained by integrating the current value from the calculation time of the used capacity to a full-charge time of the battery,

wherein the full-charge time corresponds to a discharge condition when the voltage value is greater than or equal to a predetermined full-charge voltage value and when the current value is less than a predetermined full-charge current value.

8. The battery management system of claim 6 or 7, wherein the MCU (300) further includes a maximum capacity calculating unit (307) configured to calculate the theoretical maximum capacity of the battery based at least in part on a first depth of discharge, DoD, calculated based on a first OCV value obtained at a first stabilized time prior to a last charge or prior to a last discharge of the battery, a second DoD calculated based on a second OCV value obtained at a second stabilized time after the last charge or after the last discharge of the battery, and a second integrated current value obtained by integrating the current value from the calculation time of the used capacity to the second stabilized time;

optionally wherein the maximum capacity calculating unit (307) is configured to calculate the theoretical maximum capacity when the second integrated current value is greater than or equal to a predetermined value.

9. The battery management system of claim 7 or 8, wherein the MCU (300) further includes a remaining capacity calculating unit (315) configured to calculate a remaining capacity that is available for use, using the total usable capacity, the uncharged capacity, the used capacity and a third integrated current value obtained by integrating the current value from the calculation time of the used capacity to a time when the remaining capacity is calculated.

**Patentansprüche**

1. Batterieverwaltungssystem (20), umfassend:

eine Sensoreinheit (200), die dazu ausgestaltet ist, einen Stromwert und einen Spannungswert und einen Temperaturwert einer Batterie in einem Entladungszustand der Batterie zu messen; und

eine Hauptsteuereinheit, *main controller unit -* MCU, (300), die dazu ausgestaltet ist, den Strom-, Spannungs- und Temperaturwert zu empfangen, und ferner dazu ausgestaltet ist, Kapazitäten der Batterie zumindest teilweise auf der Grundlage des Strom-, Spannungs- und Temperaturwertes zu verwalten,

wobei die MCU (300) eine Einheit zur Berechnung der nicht nutzbaren Kapazität (309) enthält, die dazu ausgestaltet ist, eine nicht nutzbare Kapazität, entsprechend einem Teil einer theoretischen maximalen Kapazität der Batterie, die in dem Entladungszustand nicht nutzbar ist, zu berechnen, wobei die nicht nutzbare Kapazität zumindest teilweise auf der Grundlage des Stromwertes und eines internen Widerstandswertes der Batterie in dem Entladungszustand berechnet wird;

wobei die MCU (300) ferner eine Einheit zur Berechnung des internen Widerstands (311) enthält, um den internen Widerstandswert der Batterie in dem Entladungszustand zu berechnen, auf der Grundlage:

einer Temperaturkorrekturvariablen, wobei die Temperaturkorrekturvariable Beziehungsdaten zwischen Temperatur und internem Widerstand bezeichnet, und

eines internen Referenzwiderstandswertes, wobei der interne Referenzwiderstand berechnet wird unter Verwendung: einer Leerlaufspannung, die unter Verwendung eines Ladezustandes der Batterie an einem willkürlichen Punkt in dem Bereich, in dem die Entladetiefe, *depth of discharge -* DoD, der Batterie im Bereich von 0 bis 0,7 liegt, geschätzt wird; des Strom- und Spannungswertes, gemessen an dem willkürlichen Punkt; und eines Wertes der Temperaturkorrekturvariablen, berechnet unter Verwendung eines Temperaturwertes, gemessen an dem willkürlichen Punkt.

2. Batterieverwaltungssystem nach Anspruch 1, wobei die nicht nutzbare Kapazität einen Teil der theoretischen maximalen Kapazität umfasst, die in der Batterie verbleibt, wenn die Größe des Spannungswertes eine Entladungsstoppspannung erreicht hat, die einer minimalen Spannung entspricht, die ausreichend ist, um eine mit der Batterie verbundene Vorrichtung anzutreiben.

3. Batterieverwaltungssystem nach Anspruch 1 oder 2, wobei die Einheit zur Berechnung der nicht nutzbaren Kapazität (309) dazu ausgestaltet ist, die nicht nutzbare Kapazität ferner auf der Grundlage zuvor gespeicherter Stromdaten in der MCU (300) und eines Proportionalitätskoeffizienten zwischen dem internen Widerstand und der nicht nutzbaren Kapazität zu berechnen;
wobei gegebenenfalls die Einheit zur Berechnung der nicht nutzbaren Kapazität (309) ferner dazu ausgestaltet ist, eine korrigierende Anpassung an den internen Widerstand der Batterie auf der Grundlage einer Korrekturvariablen, die gemäß der Größe des Stromwertes bestimmt wird, vorzunehmen.

4. Batterieverwaltungssystem nach einem der Ansprüche 1 bis 3, wobei die MCU (300) ferner eine Einheit zur Berechnung der gesamten nutzbaren Kapazität (313) enthält, die dazu ausgestaltet ist, eine gesamte nutzbare Kapazität der Batterie zumindest teilweise auf der Grundlage der theoretischen maximalen Kapazität der Batterie, einer ungeladenen Kapazität der Batterie und der nicht nutzbaren Kapazität zu berechnen.

5. Batterieverwaltungssystem nach Anspruch 4, wobei die MCU (300) ferner eine Einheit zur Berechnung der genutzten Kapazität (301) enthält, die dazu ausgestaltet ist, eine genutzte Kapazität der Batterie zumindest teilweise auf der Grundlage eines Leerlaufspannungs-, *open circuit voltage* - OCV, Wertes, gemessen zu einer Zeit, zu der die Batterie stabilisiert wurde, zu berechnen,
wobei die Zeit, zu der die Batterie stabilisiert wurde, einem Entladungszustand entspricht, der mindestens eine der Bedingungen, dass der Stromwert während einer festgelegten Zeit geringer ist als ein festgelegter Stromwert und dass eine Änderung des Spannungswertes geringer ist als ein festgelegter Spannungswert, erfüllt.

6. Batterieverwaltungssystem nach Anspruch 5, wobei die MCU (300) ferner eine Einheit zur Integration von Strom (303) enthält, die dazu ausgestaltet ist, einen integrierten Stromwert durch Integrieren des Stromwertes zumindest teilweise durch Einstellen des integrierten Stromwertes als Null zu einer Zeit, zu der die genutzte Kapazität berechnet wird, zu berechnen.

7. Batterieverwaltungssystem nach Anspruch 6, wobei die MCU (300) ferner eine Einheit zur Berechnung ungeladener Kapazität (305) enthält, die dazu ausgestaltet ist, die ungeladene Kapazität zumindest teilweise auf der Grundlage der genutzten Kapazität und eines ersten integrierten Stromwertes, ermittelt durch Integrieren des Stromwertes von der Berechnungszeit der genutzten Kapazität bis zu einer Gesamtaufladezeit der Batterie, zu berechnen, wobei die Gesamtaufladezeit einem Entladungszustand entspricht, in dem der Spannungswert größer als oder gleich ein(em) festgelegter/n Gesamtaufladespannungswert ist und in dem der Stromwert kleiner als ein festgelegter Gesamtaufladestromwert ist.

8. Batterieverwaltungssystem nach Anspruch 6 oder 7, wobei die MCU (300) ferner eine Einheit zur Berechnung der maximalen Kapazität (307) enthält, die dazu ausgestaltet ist, die theoretische maximale Kapazität der Batterie zumindest teilweise auf der Grundlage einer ersten Entladetiefe, *depth of discharge* - DoD, berechnet auf der Grundlage eines ersten OCV-Wertes, ermittelt zu einer ersten stabilisierten Zeit vor einem letzten Aufladen oder vor einem letzten Entladen der Batterie, einer zweiten DoD, berechnet auf der Grundlage eines zweiten OCV-Wertes, ermittelt zu einer zweiten stabilisierten Zeit nach dem letzten Aufladen oder nach dem letzten Entladen der Batterie, und einem zweiten integrierten Stromwert, ermittelt durch Integrieren des Stromwertes von der Berechnungszeit der genutzten Kapazität bis zu der zweiten stabilisierten Zeit, zu berechnen;
wobei gegebenenfalls die Einheit zur Berechnung der maximalen Kapazität (307) dazu ausgestaltet ist, die theoretische maximale Kapazität zu berechnen, wenn der zweite integrierte Stromwert größer als oder gleich ein(em) festgelegter/n Wert ist.

9. Batterieverwaltungssystem nach Anspruch 7 oder 8, wobei die MCU (300) ferner eine Einheit zur Berechnung der Restkapazität (315) enthält, die dazu ausgestaltet ist, eine Restkapazität, die zur Nutzung zur Verfügung steht, unter Verwendung der gesamten nutzbaren Kapazität, der ungeladenen Kapazität, der genutzten Kapazität und eines dritten integrierten Stromwertes, ermittelt durch Integrieren des Stromwertes von der Berechnungszeit der genutzten Kapazität bis zu einer Zeit, zu der die Restkapazität berechnet wird, zu berechnen.

## Revendications

1. Système de gestion de batterie (20), comprenant :

une unité de détection (200) configurée pour mesurer une valeur de courant et une valeur de tension et une valeur de température d'une batterie dans une condition de décharge de la batterie ; et
une unité de contrôleur principal, MCU, (300) configurée pour recevoir les valeurs de courant, de tension et de température et en outre configurée pour gérer les capacités de la batterie sur la base au moins en partie des valeurs de courant, de tension et de température,

dans lequel la MCU (300) comprend une unité de calcul de capacité inutilisable (309) configurée pour calculer une capacité inutilisable correspondant à une partie d'une capacité maximum théorique de la batterie qui est inutilisable dans la condition de décharge, où la capacité inutilisable est calculée sur la base au moins en partie de la valeur de courant et d'une valeur de résistance interne de la batterie dans la condition de décharge ;

dans lequel la MCU (300) comprend en outre une unité de calcul de résistance interne (311) pour calculer la valeur de résistance interne de la batterie dans la condition de décharge sur la base :

d'une variable de correction de température, où la variable de correction de température désigne des données de relation entre la température et la résistance interne, et d'une valeur de résistance interne de référence, où la résistance interne de référence est calculée en utilisant : une tension en circuit ouvert estimée en utilisant un état de charge de la batterie en un point arbitraire dans la région où la profondeur de décharge, DoD, de la batterie est dans la plage 0 à 0,7 ; des valeurs de courant et de tension mesurées au point arbitraire ; et une valeur de la variable de correction de température calculée en utilisant une valeur de température mesurée au point arbitraire.

2. Système de gestion de batterie selon la revendication 1, dans lequel la capacité inutilisable comprend une partie de la capacité maximum théorique qui reste dans la batterie lorsque l'amplitude de la valeur de tension a atteint une tension d'arrêt de décharge correspondant à une tension minimum qui est suffisante pour commander un dispositif connecté à la batterie.

3. Système de gestion de batterie selon la revendication 1 ou 2, dans lequel l'unité de calcul de capacité inutilisable (309) est configurée pour calculer la capacité inutilisable en outre sur la base de données de courant mémorisées au préalable dans la MCU (300) et d'un coefficient de proportionnalité entre la résistance interne et la capacité inutilisable ;

en option dans lequel l'unité de calcul de capacité inutilisable (309) est en outre configurée pour appliquer un ajustement de correction à la résistance interne de la batterie sur la base d'une variable de correction déterminée conformément à l'amplitude de la valeur de courant.

4. Système de gestion de batterie selon l'une quelconque des revendications 1 à 3, dans lequel la MCU (300) comprend en outre une unité de calcul de capacité utilisable totale (313) configurée pour calculer une capacité utilisable totale de la batterie au moins en partie sur la base de la capacité maximum théorique de la batterie, d'une capacité non chargée de la batterie, et de la capacité inutilisable.

5. Système de gestion de batterie selon la revendication 4,

dans lequel la MCU (300) comprend en outre une unité de calcul de capacité utilisée (301) configurée pour calculer une capacité utilisée de la batterie au moins en partie sur la base d'une valeur de tension en circuit ouvert, OCV, mesurée à un instant auquel la batterie a été stabilisée,

dans lequel l'instant auquel la batterie a été stabilisée correspond à une condition de décharge satisfaisant à au moins l'une des conditions où la valeur de courant pendant un temps prédéterminé est inférieure à une valeur de courant prédéterminée et un changement de la valeur de tension est inférieur à une valeur de tension prédéterminée.

6. Système de gestion de batterie selon la revendication 5, dans lequel la MCU (300) comprend en outre une unité d'intégration de courant (303) configurée pour calculer une valeur de courant intégrée en intégrant la valeur de courant au moins en partie en établissant à zéro la valeur de courant intégrée à un instant auquel la capacité utilisée est calculée.

7. Système de gestion de batterie selon la revendication 6, dans lequel la MCU (300) comprend en outre une unité de calcul de capacité non chargée (305) configurée pour calculer la capacité non chargée sur la base au moins en partie de la capacité utilisée et d'une première valeur de courant intégrée obtenue en intégrant la valeur de courant entre l'instant de calcul de la capacité utilisée et un instant auquel la batterie est à pleine charge,

dans lequel l'instant de pleine charge correspond à une condition de décharge lorsque la valeur de tension est supérieure ou égale à une valeur de tension de pleine charge prédéterminée et lorsque la valeur de courant est inférieure à une valeur de courant de pleine charge prédéterminée.

8. Système de gestion de batterie selon la revendication 6 ou 7, dans lequel la MCU (300) comprend en outre une unité de calcul de capacité maximum (307) configurée pour calculer la capacité maximum théorique de la batterie sur la base au moins en partie d'une première profondeur de décharge, DoD, calculée sur la base d'une première valeur d'OCV obtenue à un premier instant stabilisé avant une dernière charge ou avant une dernière décharge de la batterie, d'une deuxième DoD calculée sur la base d'une deuxième valeur d'OCV obtenue à un deuxième instant stabilisé après la dernière charge ou après la dernière décharge de la batterie, et d'une deuxième valeur de courant intégrée obtenue en intégrant la valeur de courant entre l'instant de calcul de la capacité utilisée et le deuxième instant stabilisé ;

en option dans lequel l'unité de calcul de capacité maximum (307) est configurée pour calculer la capacité maximum théorique lorsque la deuxième valeur de courant intégrée est supérieure ou égale à une valeur prédéterminée.

9. Système de gestion de batterie selon la revendication 7 ou 8, dans lequel la MCU (300) comprend en outre une unité de calcul de capacité restante (315) configurée pour calculer une capacité restante qui est disponible pour une utilisation, en utilisant la capacité utilisable totale, la capacité non chargée, la capacité utilisée et une troisième valeur de courant intégrée obtenue en intégrant la valeur de courant entre l'instant de calcul de la capacité utilisée et un instant auquel la capacité restante est calculée.

# FIG. 1

# FIG. 2

20

300

MCU

200

301

303

Sensing unit

Previously used capacity calculating unit

Current accumulating unit

305

307

Non-charge capacity calculating unit

Maximum capacity calculating unit

313

309

Entire capacity calculating unit

Non-usable capacity calculating unit

315

311

Remaining capacity calculating unit

Internal resistance calculating unit

# FIG. 3

FIG. 4

# FIG. 5

R vsDoD

# FIG. 6

# FIG. 7

Receive current data and voltage data (S700)

Is battery in stabilized state, discharge state of full-charge state? (S705)

Full Charge → Calculate uncharged capacity using used capacity and integrated current value from calculation time of used capacity to full-charge time (S715)

Stability → Calculate used capacity using OCV (S710)

Discharge → Calculate unsusable capacity using current value and internal resistance (S720)

Calculate total usable capacity using maximum capacity, uncharged capacity and unusable capacity (S725)

Calculate remaining capacity using total usable capacity, uncharged capacity, used capacity and integrated current value from calculation time of used capacity to current discharge time (S730)

EP 2 793 038 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013041607 A
- US 5936383 A
- EP 2071345 A
- US 5631540 A